# EUROPÄISCHE PATENTSCHRIFT

(11) **EP 0 310 739 B1**
(45) Veröffentlichungstag und Bekanntmachung des Hinweises auf die Patenterteilung: **13.01.1993**
(21) Anmeldenummer: 88103768.3
(22) Anmeldetag: 10.03.1988
(51) Int. Cl.: C30B 15/14

(54) **Vorrichtung zum Ziehen von Einkristallen**
Apparatus for pulling single crystals
Appareillage pour le tirage de monocristaux

(30) Priorität: 03.10.1987 DE 3733487
(43) Veröffentlichungstag der Anmeldung: 12.04.1989
(73) Patentinhaber: LEYBOLD AKTIENGESELLSCHAFT, D-63450 Hanau (DE)
(72) Erfinder: Drechsel, Dieter, Dr., D-6454 Bruchköbel (DE); Jericho, Karl, D-6450 Hanau 9 (DE)

(56) Entgegenhaltungen:
- EP-A- 0 141 649
- DE-A- 1 519 881
- DE-A- 3 506 754
- GB-A- 2 166 062
- PATENT ABSTRACTS OF JAPAN, Band 9, Nr. 145 (C-287), 20 Juni 1985; & JP - A - 60 027 683

## Beschreibung

Die Erfindung betrifft eine Vorrichtung zum Ziehen von Einkristallen aus einer in einem Tiegel befindlichen Schmelze unter Vakuum mit einer Vakuumkammer, in der der Tiegel angeordnet ist, mit einem in einer zur Bodenfläche des Tiegels parallelen Ebene sich erstreckenden, etwa ringförmigen, flachen ersten Heizkörper, mit einem Ziehelement oberhalb der Schmelze und mit einer eine Öffnung aufweisenden Abdeckung über der Schmelze, durch die der Einkristall mittels des Ziehelements von der Schmelzenoberfläche aus nach oben durchziehbar ist und die durch die Wärmestrahlung des Heizelements erhitzbar ist.

Beim Ziehen von Einkristallen unter Vakuumbedingungen aus einer Schmelze kommt es wesentlich darauf an, die Temperaturverhältnisse am Tiegelrand so niedrig als möglich zu halten und sich in der Schmelze bildende Strömungen zu vermeiden.

Um beim Ziehen von Einkristallen nachteiligen Einwirkungen entgegenzuwirken, wurde bereits bei einer bekannten Vorrichtung zum Ziehen von Einkristallen (US 3,359,077) eine Schmelzabdeckung zur Herabsetzung des Wärmegradienten an der Oberfläche der Schmelze vorgesehen.

Weiterhin ist es bekannt (EP-A 170 856), den Tiegel für die Schmelze zweischalig auszubilden und mit einem kreiszylindrischen Einsatz zu versehen und den Einfülltrichter einer Nachchargiervorrichtung so anzuordnen, daß das Nachchargiergut in einen zwischen dem Rand der inneren Schale des Tiegels und dem Einsatz verbleibenden Randpartie einfüllbar ist. Diese vorbekannte Vorrichtung ist außerdem bereits mit zwei Heizvorrichtungen ausgestattet, von denen die eine eine flache, kreisscheibenförmige Konfiguration aufweist und unterhalb des Tiegels gehalten ist und die andere als hohlzylindrischer, den Tiegel umschließender Körper ausgeformt ist.

Schließlich ist bereits eine Vorrichtung bekannt (US 3,511,610), die dazu dient, einen übermäßig großen Temperaturunterschied zwischen dem Ende des Keimkristalls und der Schmelze herabzusetzen, wozu der den Keimkristall tragende Teil mit einer Erhitzungsvorrichtung versehen ist, von welchem die Hitze auf den Keimkristall unter Zuhilfenahme des Trägers für den letzteren überführt werden kann. Hierzu dient eine Platte an dem Ziehelement für den Kristallhalter.

Der vorliegenden Erfindung liegt nun die Aufgabe zugrunde, das Aufschmelzen des kontinuierlich zugeführten Chargengutes zu verbessern, eine möglichst weitgehende Badbeunruhigung beim Chargieren während des Ziehvorgangs zu vermeiden und Temperaturerhöhungen der Tiegelwand infolge von Energiedurchgang zum Aufschmelzen des Nachchargiergutes zu verhindern.

Erfindungsgemäß wird diese Aufgabe durch einen in einer zur Bodenfläche des Tiegels parallelen Ebene sich erstreckenden, etwa ringförmigen, flachen ersten Heizkörper und einem im wesentlichen kreiszylindrischen, den Tiegel zumindest teilweise umschließenden, zur Ebene des ersten Heizkörpers senkrecht angeordneten zweiten Heizkörper erreicht, der an seinem oberen Ende in einen etwa plattenförmigen, zum ersten Heizkörper parallelen Heizkörper übergeht, der in einer Ebene zwischen dem oberen Rand des Tiegels und der Unterseite der kreisringförmigen Abdeckung angeordnet ist.

Die als Flanschteil ausgebildete und die Schmelze zumindest teilweise von ober her abdeckende Partie des zweiten Heizkörpers ermöglicht eine unmittelbare Aufheizung des nachchargierten Schmelzgutes, ohne daß der Tiegel insgesamt einer Aufheizung ausgesetzt wird.

Anstelle eines kreizylindrischen, mit einem ringförmigen, flachen Teil ausgestatteten zweiten Heizkörpers kann auch ein im wesentlichen kreisscheibenförmiger, flacher zweiter Heizkörper vorgesehen sein, dessen ringförmiges, flaches Teil in einer Ebene zwischen dem oberen Rand des Tiegels und der Unterseite der kreisringförmigen Abdeckung angeordnet ist, wobei das ringförmige, flache Teil einen oder mehrere sich lotrecht nach unten zu erstreckende Heizerfüße aufweist, die in Ausnehmungen eingreifen, die an den Spannbacken vorgesehen sind, wobei die Heizerfüße in den Ausnehmungen verklemmt, verkeilt oder verschraubt sind.

Die Stromversorgung sowohl des ersten (den Tiegel aufheizenden bzw. temperierenden) als auch des zweiten (direkt auf das Chargiergut einwirkenden) Heizkörpers erfolgt zweckmäßigerweise getrennt, da die Heizleistung des zweiten Heizkörpers direkt von der in der Zeiteinheit zugeführten Nachchargiermenge abhängt.

Vorzugsweise ist der plattenförmige erste Heizkörper von mindestens zwei parallel zum Tiegeltragbolzen angeordneten, stabförmigen Stromzuführungen gehalten, wobei die Stromzuführungen einerseits an der Bodenplatte für den Kessel isoliert hindurchgeführt sind und andererseits an den Heizerfüßen des ersten Heizkörpers befestigt sind.

Die mit den Stromzuführungen fest verbundenen Heizerfüßen des ersten Heizkörpers sind dabei über zwei im wesentlichen halbkreisförmige Partien verbunden, wobei diese eine zentrale Öffnung einschließenden Partien aus mäanderförmig gebogenen Heizschlangen gebildet sind.

Mit Vorteil ist das ringförmige, flache Teil des zylindrisch ausgebildeten zweiten Heizkörpers mit einer Vielzahl von auf seinem Umfang verteilt angeordneten Schlitzen versehen, die sich bis in den Bereich der kreiszylindrischen Seitenwand hinein erstrecken.

Alternativ oder auch zusätzlich ist die Seitenwand des im wesentlichen kreiszylindrisch ausgebildeten zweiten Heizkörpers mit einer Vielzahl von auf dem Umfang der Seitenwand verteilt angeordneten Schlitzen ausgestattet, die sich von der unteren Heizkörperkante bis in den Bereich des sich radial nach innen zu erstreckenden ringförmigen, flachen Teils hinein erstrecken.

Zweckmäßigerweise weist die Seitenwand des zweiten Heizkörpers sich nach unten zu erstreckende Heizerfüße auf, die in Ausnehmungen eingreifen, die an sich radial nach innen zu erstreckenden, von den Stromzuführungen gehaltenen Spannbacken vorgesehen sind, wobei die Fußteile des zweiten Heizkörpers mit Hilfe von Keilen in den etwa rechteckigen Ausnehmungen verkeilt oder dort verschraubt oder vernietet sind.

Um die kontinuierliche Zuführung des Chargengutes zu gewährleisten, weist der ringförmige, flache Teil des kreiszylindrischen zweiten Heizkörpers Öffnungen oder Aussparungen auf, durch die der Einfülltrichter eines Zuführrohres der Chargiervorrichtung hindurchgreift, die außerhalb des Kessels vorgesehen ist.

Vorzugsweise sind der Tiegel und die beiden Heizkörper zumindest teilweise von einem im wesentlichen zylindrischen Schutzrohr umschlossen, das mit seinen unteren, Aussparungen aufweisenden Rand auf einer Schmelzgut-Auffangwanne ruht, die ihrerseits auf der Kesselbodenplatte von einem, Rohr gehalten ist, wobei die Schmelzgut-Auffangwanne sich in einer Ebene, parallel zur Ebene der Bodenfläche des Tiegels erstreckt und eine zentrale Bohrung aufweist, durch die der lotrechte Tiegeltragbolzen hindurchgeführt ist.

Damit eine gleichmäßige Wärmeverteilung bei geringsten Wärmeverlusten gewährleistet ist, sind sowohl die Wanne zum Auffangen des Schmelzgutes bei Tiegelbruch als auch das Schutzrohr und die oberhalb des Tiegels angeordnete, vom Schutzrohr getragene Abdeckplatte mit Isolierstoffmatten, vorzugsweise aus Graphitfilz, verkleidet.

Um eine Beunruhigung der Schmelze zu vermeiden, ist ein in den Schmelztiegel konzentrisch eingesetzter hohlzylindrischer, mit Öffnungen oder Ausbrüchen für den Durchtritt der Schmelze versehener Ring aus einem mit der Schmelze nicht reagierenden Werkstoff vorgesehen, wobei der Einfülltrichter für das Chargiergut in einen Bereich einmündet, der von der Außenfläche des Rings und dem Tiegelrand begrenzt ist.

Eine Verunreinigung der Schmelze wird auch dadurch ausgeschlossen, daß die Innenwand des Tiegels mit einer Schale oder einem Einsatz aus einem mit der Schmelze nicht reagierenden Werkstoff versehen ist und daß zumindest das oberhalb des Tiegels angeordnete ringförmige, flache Teil des zweiten Heizkörpers beschichtet ist.

Die Erfindung läßt die verschiedensten Ausführungsmöglichkeiten zu; eine davon ist in den anhängenden Zeichnungen näher dargestellt, und zwar zeigen:

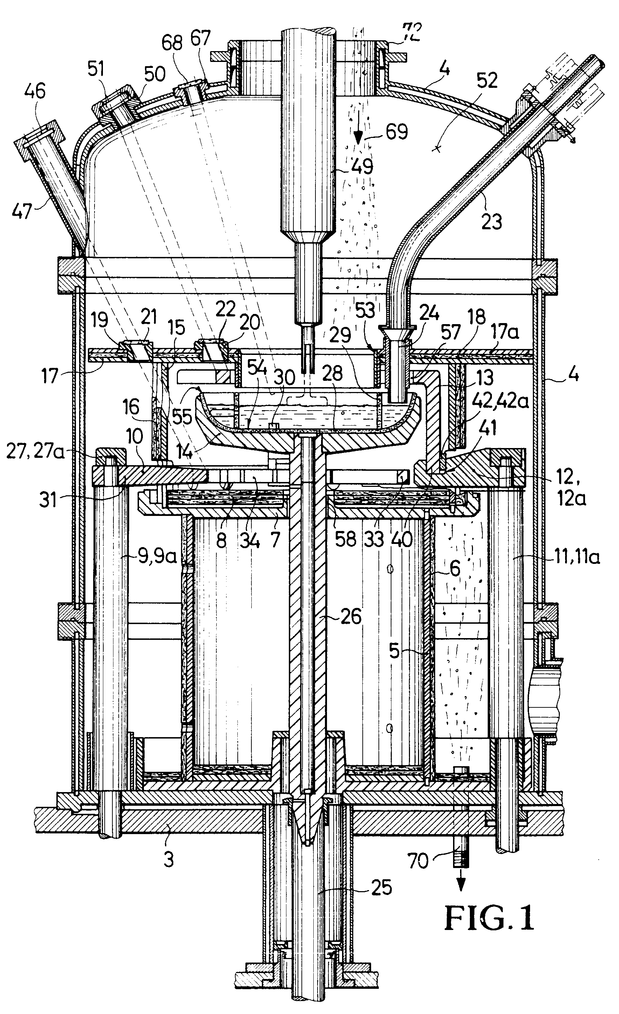

- Figur 1: die Teilansicht einer Vorrichtung zum Ziehen von Einkristallen im Längsschnitt
- Figuren 2 & 3: den Bodenheizer gemäß Figur 1 in der Draufsicht und im Schnitt nach den Linien A-A
- Figur 4: das den Schmelztiegel und die Heizung seitlich umschließende Strahlschutzrohr
- Figuren 5 & 6: die Draufsicht auf den Zylinderheizer gemäß Figur 1 und einen Längsschnitt nach den Linien B-B
- Figuren 7 - 9: verschiedene Ansichten eines alternativen ringförmigen, flachen Heizkörpers
Die Vorrichtung besteht im wesentlichen aus einem auf der doppelwandigen Kesselbodenplatte 3 des Vorrichtungsgestells aufgesetzten, ebenfalls doppelwandigen Kessel 4, der eine Vakuumkammer 52 bildet, einem im Kessel 4 angeordneten, auf der Kesselbodenplatte 3 gelagerten Stützrohr 5 mit einer dieses umschließenden Wärmedämmung 6, einer vom Stützrohr 5 gehaltenen, ringförmigen Wanne 7, mit in dieser gelagerten Graphitfilzplatten 8, zwei an der Kesselbodenplatte 3 gehaltenen Stromzuführungen 9, 9a für einen oberhalb der Wanne 7 gehaltenen Bodenheizer 10, zwei weiteren in der Kesselbodenplatte 3 gehaltenen Stromzuführungen 11, 11a, mit denen jeweils Spannbacken 12, 12a verschraubt sind, die ihrerseits einen Stirn- oder Zylinderheizer 13 tragen, einem Schmelztiegel 14, einem sich auf der Wanne 7 abstützenden Strahlschutzrohr 15 mit seitlicher Wärmedämmung 16, einer vom Strahlschutzrohr 15 getragenen Abdeckplatte 17 mit einer oberen stirnseitigen Wärmedämmung 18 und Durchführungen 19, 20 mit Schutzgläsern 21, 22, einem Zuführrohr 23 für das Chargengut, einem durch die Abdeckplatte 17, 17a hindurchgeführten Einfülltrichter 24 und der drehbaren und auf und ab bewegbaren Tiegelwelle 25 zur Halterung des Tiegeltragbolzens 26.

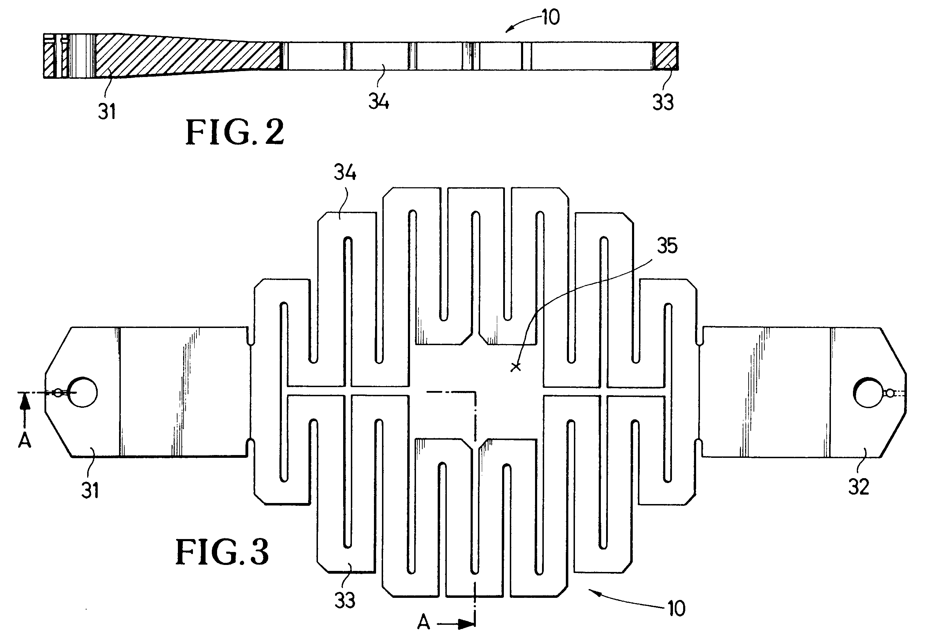

Der von den beiden Stromzuführungen 9, 9a gehaltene Bodenheizer 10 ist in den Figuren 2 und 3 dargestellt und besteht aus den beiden einander gegenüberliegenden seitlichen Heizerfüßen 31, 32 und den zwei jeweils mäanderförmig ausgeformten Heizschlangen 33, 34. Die Heizschlangen 33, 34 bilden zusammen im Zentrum des Bodenheizers 10 eine Öffnung 35, durch die sich der Tiegeltragbolzen 26 hindurch erstreckt, der mit seinem oberen Ende mit dem Schmelztiegel fest verbunden ist und über den der Schmelztiegel 14 sowohl auf und ab bewegt als auch in eine Drehbewegung versetzt werden kann.

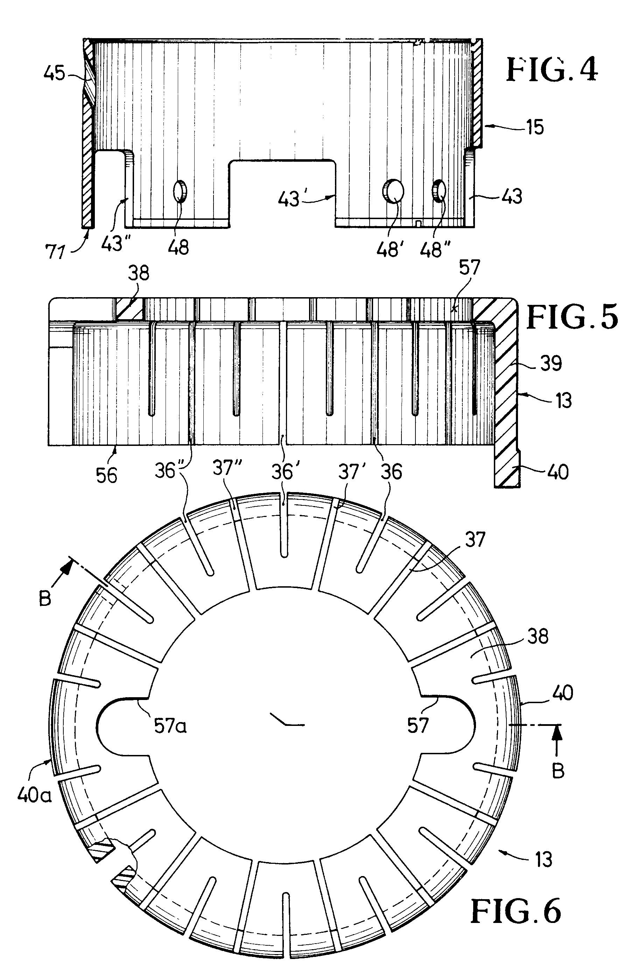

Der in den Figuren 5 und 6 näher dargestellte Stirnheizer 13 ist aus einem kreisringförmigen, mit radial verlaufenden Schlitzen 36, 36', ... bzw. 37, 37', ... versehenen, ringförmigen, flachen Teil 38 und einer hohlzylindrischen Seitenwand 39 gebildet. Das hohlzylindrische Teil 39 ist an zwei einander gegenüberliegenden Partien mit sich nach unten zu erstreckenden Heizerfüßen 40, 40a versehen, die jeweils in Ausnehmungen 41, 41a eingreifen, die in den von den Stromzuführungen 11, 11a gehaltenen beiden Spannbacken 12, 12a vorgesehen sind. Um einen sicheren Stromübergang des Stirnheizers 13 in den beiden Ausnehmungen 41, 41a der Spannbacken 12, 12a zu gewährleisten, sind zusätzliche Keile 42, 42a in die trapezförmigen Ausnehmungen 41, 41a eingetrieben.

Das in Figur 4 dargestellte Strahlschutzrohr 15 weist vier rechteckige Aussparungen 43, 43', ... auf, die - gleichmäßig auf dem Umfang des Strahlschutzrohrs 15 verteilt - an dessen unterem Rand 57 angeordnet sind. Durch diese Aussparungen 43, 43', ... sind zum einen die Spannbacken 12, 12a und zum anderen die Heizerfüße 31, 32 des Bodenheizers 10 hindurchgeführt. Weiterhin ist das Strahlschutzrohr 15 mit einer schräg verlaufenden Bohrung 45 versehen, die mit dem Schutzglas 21 der Abdeckplatte 17, 17a und dem Schutzglas 46 des in der Wand des Kessels 4 befestigten Stutzens 47 fluchtet. Weitere Öffnungen 48, 48', 48'', ... in der Seitenwand des Strahlschutzrohrs 15 gestatten einen unbehinderten Gasdurchtritt vom oberen Abschnitt des Innenraums des Kessels 4 in den unteren Abschnitt. Der Kessel 4 ist im übrigen im Bereich seiner Deckelpartie 4' mit einem Kragen 72 versehen, der den Durchtritt des Ziehelements 49 gestattet. Es sei noch erwähnt, daß in der Deckelpartie 4' des Kessels außerdem ein weiterer Stutzen 50 mit einem Schauglas 51 vorhanden ist.

An die zwei Stromzuführungen 9, 9a ist der Bodenheizer 10, der mäanderförmig geschlitzt ist, über Graphitmuttern 27, 27a angeschraubt. Der Bodenheizer 10 hat die Aufgabe, den Tiegel bzw. die Schmelze von der unteren Stirnseite her zu beheizen. An zwei zusätzlichen Stromzuführungen 11, 11a ist ein zweiter Heizkörper 13, der als Topfheizer ausgeführt ist, über Spannbacken 12, 12a befestigt. Die obere Stirnheizung verbessert das Aufschmelzen des kontinuierlich zugeführten Chargengutes. Der Stirnheizer 13 kann im Falle einer Siliziumschmelze mit SiC beschichtet bzw. abgedeckt sein, um zu vermeiden, daß Graphitteilchen in die Schmelze fallen und Kohlenstoff-Verunreinigungen ergeben. Auch wird eine Reaktion von SiO mit Graphit (2C + SiO → SiC + CO) verhindert. Die strichliert eingezeichnete Linie zeigt einen Argon-Gasstrom, der über den Kragen 48, durch die zentrale Öffnung 53, über die Schmelze bzw. um den Tiegel 14 herum, durch die Öffnungen 48, 48', ... hindurch nach unten zu strömt und schließlich über den Rohrstutzen 70 abgezogen wird.

Im Zentrum der Heizeinrichtung befindet sich ein Graphittiegel 14, in den ein Tiegel 28, der aus einem nicht mit der Schmelze reagierenden Werkstoff gebildet ist, eingesetzt ist. Um eine Badberuhigung beim Chargieren während des Ziehvorgangs zu gewährleisten, ist ein zusätzlicher Ring 29, der ebenfalls aus einem nicht mit der Schmelze reagierenden Werkstoff gebildet ist, in den Tiegel 28 eingesetzt. In dem Ring 29 befinden sich am unteren Ende Ausbrüche 30, durch die das aufgeschmolzene Chargengut in die Mitte des Tiegeleinsatzes 28 fließen kann. Um beide Heizer 10, 13 ist eine Wärmedämmung 8, 16, 18 angebracht, die aus der Wanne 7, aus zusätzlichen Graphitfilzplatten 8, einer seitlichen Wärmedämmung 16, die als Zylinder ausgebildet und auf das Strahlschutzrohr 15 aufgeschoben ist, und einer oberen stirnseitigen Wärmedämmung 18 besteht. Die oberen Scheiben 17, 17a stützen sich - zusammen mit der Wärmedämmung 18 - an der Innenfläche des Kessels 4 ab.

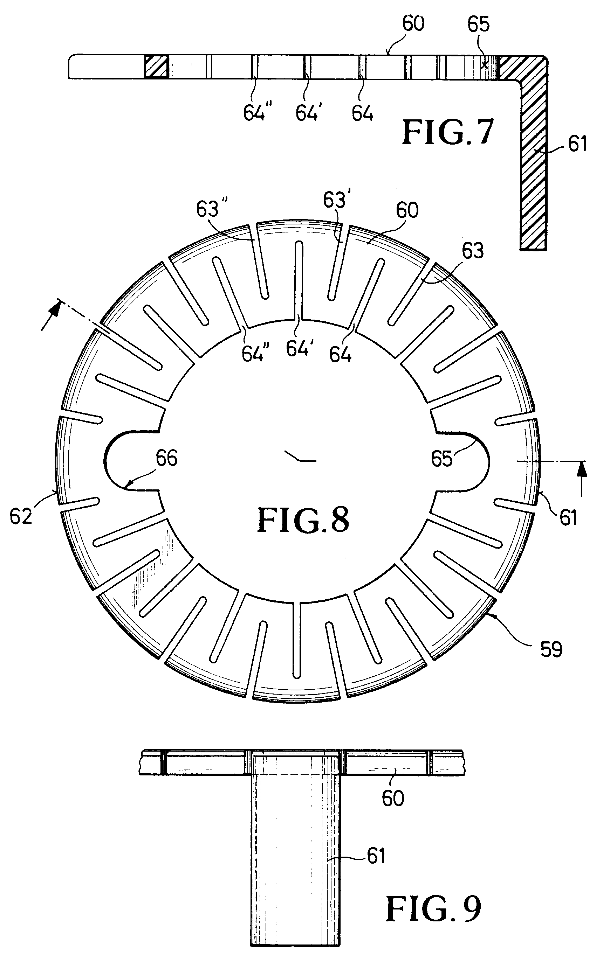

In den Figuren 7 bis 9 ist ein Heizkörper 59 dargestellt, der alternativ als zweiter Heizkörper verwendet werden kann. Dieser Heizkörper 59 besteht im wesentlichen aus einem mäanderartig geschlitzten, ringförmigen, flachen Teil 60 mit zwei rechtwinklig zu diesem Teil angeordneten Heizerfüßen 61, 62. Die Temperatur des Heizkörpers 59 läßt sich individuell einstellen, wozu über den Stutzen 67 im Deckel des Kessels 4 die Temperatur der Schmelze im Tiegel 14, 28 gemessen werden kann. Wenn über den Einfülltrichter 24 noch ungeschmolzenes Gut der Schmelze im Tiegel 14, 28 zugeführt wird, läßt sich allein über den zweiten Heizkörper (Figuren 4 bis 6 bzw. Figuren 7 bis 9) ein sofortiges und rasches Schmelzen dieses Nachchargiergutes bewirken, was mit einer vergleichsweise minimalen Beunruhigung der Schmelze erzielt werden kann, und zwar ohne daß sich der Tiegel 14, 28 selbst dabei stärker aufheizt.

### Bezugszeichenliste

- 3: Kesselbodenplatte
- 4, 4': Kessel
- 5: Stützrohr
- 6: Wärmedämmung
- 7: Schmelzgut-Auffangwanne
- 8: Graphitfilzplatten
- 9, 9a: Stromzuführung
- 10: Bodenheizer; ringförmiger, flacher erster Heizkörper
- 11, 11a: Stromzuführung
- 12, 12a: Spannbacke
- 13: Stirnheizer, Zylinderheizer; zweiter Heizkörper
- 14: Stütztiegel
- 15: Strahlschutzrohr
- 16: Wärmedämmung
- 17, 17a: Abdeckplatte
- 18: Wärmedämmung
- 19: Durchführung
- 20: Durchführung
- 21: Schutzglas
- 22: Schutzglas
- 23: Zuführrohr
- 24: Einfülltrichter
- 25: Tiegelwelle
- 26: Tiegeltragbolzen
- 27, 27a: Graphitmutter
- 28: Tiegeleinsatz
- 29: Ring
- 30: Ausbruch
- 31: Heizerfuß
- 32: Heizerfuß
- 33: Heizschlange
- 34: Heizschlange
- 35: Öffnung
- 36, 36',: Schlitz
- 37, 37',: Schlitz
- 38: ringfömiges, flaches Heizelement
- 39: hohlzylindrischer Heizer
- 40, 40a: Heizerfuß
- 41, 41a: Ausnehmung
- 42, 42a: Keil
- 43, 43a: Aussparung
- 45: Schrägbohrung
- 46: Schauglas
- 47: Stutzen
- 48, 48',: Öffnung
- 49: Ziehelement
- 50: Stutzen
- 51: Schauglas
- 52: Vakuumkammer
- 53: zentrale Öffnung
- 54: Tiegelbodenfläche
- 55: Tiegelrand
- 56: untere Heizkörperkante
- 57, 57a: Aussparung, Öffnung
- 58: zentrale Öffnung
- 59: ringförmiger, flacher zweiter Heizkörper
- 60: mäanderartig geschlitztes, ringförmiges, flaches Heizkörperteil
- 61: Heizerfuß
- 62: Heizerfuß
- 63: Schlitz
- 64: Schlitz
- 65: Ausnehmung
- 66: Ausnehmung
- 67: Stutzen
- 68: Schauglas
- 69: Argon-Gasstrom
- 70: Rohrstutzen
- 71: unterer Rand
- 72: Kragen

## Patentansprüche

1. Vorrichtung zum Ziehen von Einkristallen aus einer in einem Tiegel (14, 28) befindlichen Schmelze unter Vakuum mit einer Vakuumkammer (52), in der der Tiegel (14, 28) angeordnet ist, mit einem in einer zur Bodenfläche (54) des Tiegels (14, 28) parallelen Ebene sich erstreckenden, etwa ringförmigen, flachen ersten Heizkörper (10), mit einem Ziehelement (49) oberhalb der Schmelze und mit einer eine Öffnung (53) aufweisenden Abdeckung (17, 17a, 18) über der Schmelze, durch die der Einkristall mittels des Ziehelements (49) von der Schmelzenoberfläche aus nach oben durchziehbar ist und die durch die Wärmestrahlung eines Heizelements (10) erhitzbar ist, **gekennzeichnet durch** einen im wesentlichen kreiszylindrischen, den Tiegel (14, 28) zumindest teilweise umschließenden, zur Ebene des ersten Heizkörpers (10) senkrecht angeordneten zweiten Heizkörper (13), dessen obere Kante in einen etwa plattenförmigen, zum ersten Heizkörper (10) parallelen Heizkörper (38) übergeht, der in einer Ebene zwischen dem oberen Rand (55) des Tiegels (14, 28) und der Unterseite der kreisringförmigen Abdeckung (17, 17a, 18) angeordnet ist.

2. Vorrichtung zum Ziehen von Einkristallen aus einer in einem Tiegel (14, 28) befindlichen Schmelze unter Vakuum mit einer Vakuumkammer (52), in der der Tiegel (14, 28) angeordnet ist, mit einem in einer zur Bodenfläche (54) des Tiegels (14, 28) parallelen Ebene sich erstreckenden, etwa ringförmigen, flachen ersten Heizkörper (10) und mit einer eine Öffnung (53) aufweisenden Abdeckung (17, 17a, 18) über der Schmelze, durch die der Einkristall mittels des Ziehelements (49) von der Schmelzenoberfläche aus nach oben durchziehbar ist, **gekennzeichnet durch** einen im wesentlichen ringförmigen, flachen zweiten Heizkörper (59) der in einer Ebene zwischen dem oberen Rand (55) des Tiegels (14, 28) und der Unterseite der kreisringförmigen Abdeckung (17, 17a, 18) angeordnet ist, wobei der zweite Heizkörper (59) einen oder mehrere sich lotrecht nach unten zu erstreckende Heizerfüße (61, 62) aufweist, die in Ausnehmungen (41, 41a) eingreifen, die an Spannbacken (12, 12a) vorgesehen sind, die mit den Stromzuführungen (11, 11a) fest verbunden sind, wobei die Heizerfüße in den Ausnehmungen verklemmt, verkeilt oder verschraubt sind.

3. Vorrichtung nach Anspruch 1 oder 2, **dadurch gekennzeichnet,** daß der ringförmige, flache erste Heizkörper (10) an mindestens zwei lotrecht angeordneten, stabförmigen Stromzuführungen (9, 9a) befestigt ist, wobei die Stromzuführungen (9, 9a) an der Kesselbodenplatte (3) des Kessels (4, 4') befestigt und über Isolatoren nach außen geführt sind.

4. Vorrichtung nach den Ansprüchen 1 bis 3, **dadurch gekennzeichnet,** daß die mit den Stromzuführungen (9, 9a) fest verbundenen Heizerfüße (31, 32) des ersten Heizkörpers (10) über zwei im wesentlichen halbkreisförmige Partien verbunden sind, wobei diese eine zentrale Öffnung (35) einschließenden Partien aus mäanderförmig gebogenen Heizschlangen (33, 34) gebildet sind.

5. Vorrichtung nach den Ansprüchen 1 und 3, **dadurch gekennzeichnet,** daß der ringförmige, flache Teil des zylindrisch ausgebildeten zweiten Heizkörpers (13) mit einer Vielzahl von auf seinem Umfang verteilt angeordneten Schlitzen (37, 37', ...) versehen ist, die sich bis in den Bereich der kreiszylindrischen Seitenwand (39) hinein erstrecken.

6. Vorrichtung nach den Ansprüchen 1, 3 und 5, **dadurch gekennzeichnet,** daß die Seitenwand (39) des im wesentlichen kreiszylindrisch ausgebildeten zweiten Heizkörpers (13) mit einer Vielzahl von auf dem Umfang der Seitenwand (39) verteilt angeordneten Schlitzen (36, 36', ...) versehen ist, die sich von der unteren Heizkörperkante (56) bis in den Bereich des sich radial nach innen zu erstreckenden ringförmigen, flachen Teil (38) des Heizkörpers (13) hinein erstrecken.

7. Vorrichtung nach einem oder mehreren der vorhergehenden Ansprüche, **dadurch gekennzeichnet,** daß die Seitenwand (39) oder das ringförmige, flache Teil (60) des zweiten Heizkörpers (13, 59) sich nach unten zu erstreckende Fußteile (40, 40a bzw. 61, 62) aufweist, die in Ausnehmungen (41, 41a) eingreifen, die an sich radial nach innen zu erstreckenden, von den Stromzuführungen (11, 11a) gehaltenen Spannbacken (12, 12a) vorgesehen sind, wobei die Fußteile (40, 40a) des zweiten Heizkörpers (13) mit Hilfe von Keilen (42, 42a) in den etwa rechteckigen Ausnehmungen (41, 41a) verkeilt oder dort verschraubt oder vernietet sind.

8. Vorrichtung nach einem oder mehreren der vorhergehenden Ansprüche, **dadurch gekennzeichnet,** daß der ringförmige, flache Teil (38, 60) des zweiten Heizkörpers (13, 59) Öffnungen oder Aussparungen (57, 57a bzw. 65, 66) aufweist, durch die der Einfülltrichter (24) eines Zuführrohrs (23) einer Chargiervorrichtung hindurchgreift, die außerhalb des Kessels (4, 4') vorgesehen ist.

9. Vorrichtung nach einem oder mehreren der vorhergehenden Ansprüche**, dadurch gekennzeichnet,** daß der Tiegel (14, 28) und die beiden Heizkörper (10 bzw. 13, 59) zumindest teilweise von einem im wesentlichen zylindrischen Schutzrohr (15) umschlossen sind, das mit seinem unteren, Aussparungen (43, 43', ...) aufweisenden Rand (71) auf einer Schmelzgut-Auffangwanne (7) ruht, die ihrerseits auf der Kesselbodenplatte (3) von einem Sockelteil oder Rohr (5) gehalten ist, wobei die Schmelzgut-Auffangwanne (7) sich in einer Ebene parallel zur Ebene der Bodenfläche (54) des Tiegels (14, 28) erstreckt und eine zentrale Bohrung (58) aufweist, durch die der lotrechte Tiegeltragbolzen (26) hindurchgeführt ist.

10. Vorrichtung nach einem oder mehreren der vorhergehenden Ansprüche, **dadurch gekennzeichnet,** daß sowohl die Schmelzgut-Auffangwanne (7) als auch das Schutzrohr (15) und die oberhalb des Tiegels (14, 28) angeordnete, vom Schutzrohr (15) getragene Abdeckplatte (17, 17a) mit Isolierstoffmatten (8, 16, 18) vorzugsweise aus Graphitfilz, verkleidet sind.

11. Vorrichtung nach einem oder mehreren der vorhergehenden Ansprüche, **gekennzeichnet durch** einen in den Schmelztiegel (14, 28) konzentrisch eingesetzten hohlzylindrischen, mit Öffnungen oder Ausbrüchen (30) für den Durchtritt der Schmelze versehenen Ring (29) aus einem nicht mit der Schmelze reagierenden Werkstoff.

12. Vorrichtung nach einem oder mehreren der vorhergehenden Ansprüche, **dadurch gekennzeichnet,** daß die Innenwand des Tiegels (14) mit einer Schale oder einem Einsatz (28) aus einem nicht mit der Schmelze reagierenden Werkstoff versehen ist und der Einfülltrichter (24) in einen Bereich des Tiegels (14, 28) einmündet, der einerseits von der Außenwand des Rings (29) und andererseits vom Tiegelrand (55) begrenzt ist.

13. Vorrichtung nach einem oder mehreren der vorhergehenden Ansprüche, **dadurch gekennzeichnet,** daß zumindest der oberhalb des Tiegels (14, 28) angeordnete ringförmige, flache Teil (38, 60) des zweiten Heizkörpers (13, 59) mit einem abrieb- und zunderfreien Werkstoff abgedeckt ist, der sicherstellt, daß keine Bestandteile des Heizkörpers in die Schmelze fallen.

14. Vorrichtung nach einem oder mehreren der vorhergehenden Ansprüche, **dadurch gekennzeichnet,** daß das ringförmige, flache Teil (60) des zweiten Heizkörpers (59) eine Vielzahl von sich radial erstreckenden Schlitzen (63, 63', ... bzw. 64, 64', ...) aufweist und mit mindestens einem sich vom Rand des flachen Teils (60) aus lotrecht nach unten zu erstreckenden Heizerfuß (61, 62) versehen ist.

## Claims

1. A device for drawing monocrystals from a melt contained in a crucible (14, 28), in a vacuum, with a vacuum chamber (52) in which the crucible (14, 28) is arranged, with an approximately ring-shaped, flat, first heating element (10) extending in a plane parallel to the base surface (54) of the crucible (14, 28), with a drawing element (49) above the melt, and with a cover (17, 17a, 18), provided with an opening (53), above the melt, through which the monocrystal can be drawn upwards from the melt surface by means of the drawing element (49), and which can be heated by the thermal radiation of a heating element (10), characterised by a substantially circular-cylindrical second heating element (13) which at least partially surrounds the crucible (14, 28), is arranged at right angles to the plane of the first heating element (10), and whose upper edge continues into an approximately plate-shaped heating element (38) which extends in parallel to the first heating element (10) and which is arranged in a plane between the upper edge (55) of the crucible (14, 28) and the underside of the circular-ring shaped cover (17, 17a, 18).

2. A device for drawing monocrystals from a melt, contained in a crucible (14, 28), in a vacuum, with a vacuum chamber (52) in which the crucible (14, 28) is arranged, with an approximately ring-shaped, flat, first heating element (10) extending in a plane parallel to the base surface (54) of the crucible (14, 28), and with a cover (17, 17a, 18), provided with an opening (53), above the melt, through which the monocrystal can be drawn upwards from the melt surface by means of the drawing element (49), characterised by a substantially ring-shaped, flat, second, heating element (59) which is arranged in a plane between the upper edge (55) of the crucible (14, 28) and the underside of the circular-ring shaped cover (17, 17a, 18), where the second heating element (59) comprises one or more heater feet (61, 62) which extend vertically downwards and engage into recesses (41, 41a) formed in clamping jaws (12, 12a) which are permanently connected to the current conductors (11, 11a), where the heater feet are clamped, wedged or screwed into the recesses.

3. A device as claimed in Claims 1 or 2, characterised in that the ring-shaped, flat, first heating element (10) is attached to at least two perpendicularly disposed, rod-like current conductors (9, 9a), where the current conductors (9, 9a) are attached to the tank base plate (3) of the tank (4, 4') and are led to the exterior via insulators.

4. A device as claimed in Claims 1 to 3, characterised in that the heater feet (31, 32), which are permanently connected to the current conductors (9, 9a), of the first heating element (10) are connected via two substantially semicircular parts, where these parts, which enclose a central opening (35), are formed by heating coils (33, 34) bent in serpentine formation.

5. A device as claimed in Claims 1 and 3, characterised in that the ring-shaped, flat part of the cylindrical, second heating element (13) is provided with a plurality of slots (37, 37',...) which are distributed over its periphery and which extend into the region of the circular-cylindrical side wall (39).

6. A device as claimed in Claims 1, 3 and 5, characterised in that the side wall (39) of the substantially circular-cylindrical second heating element (13) is provided with a plurality of slots (36, 36',...) which are distributed over the periphery of the side wall (39) and which extend from the lower edge (56) of the heating element into the region of the radially inwardly extending, ring-shaped, flat part (38) of the heating element (13).

7. A device as claimed in one or several of the preceding claims, characterised in that the side wall (39) or the ring-shaped, flat part (60) of the second heating element (13, 59) comprises downwardly extending feet members (40, 40a and 61, 62) which engage into recesses (41, 41a) formed in radially inwardly extending clamping jaws (12, 12a) supported by the current conductors (11, 11a), where the feet members (40, 40a) of the second heating element (13) are wedged in the approximately rectangular recesses (41, 41a) with the aid of wedge-shaped components (42, 42a), or are screwed or riveted therein.

8. A device as claimed in one or more of the preceding claims, characterised in that the ring-shaped, flat part (38, 60) of the second heating element (13, 59) comprises openings or cut-outs (57, 57a and 65, 66) through which the feeding funnel (24) of a supply tube (23) of a charging device, which is arranged outside of the tank (4, 4'), engages.

9. A device as claimed in one or more of the preceding claims, characterised in that the crucible (14, 28) and the two heating elements (10 and 13, 59) are at least partially enclosed by a substantially cylindrical shield tube (15) whose lower edge (71), which contains openings (43, 43',...), rests on a melt material collecting trough (7) which is itself supported on the tank base plate (3) by a support member or tube (5), where the melt material collecting trough (7) extends in a plane parallel to the plane of the base surface (54) of the crucible (14, 28) and contains a central bore (58) through which the perpendicular crucible support rod (26) extends.

10. A device as claimed in one or more of the preceding claims, characterised in that both the melt material collecting trough (7) and the shield tube (15) and the cover plate (17, 17a), which is arranged above the crucible (14, 28) and is supported by the shield tube (15), are clad with insulating mats (8, 16, 18), preferably composed of graphite felt.

11. A device as claimed in one or more of the preceding claims, characterised by a hollow-cylindrical ring (29) which is inserted concentrically into the melting crucible (14, 28), is provided with openings or cut-outs (30) for the passage of the melt, and is composed of a material which does not react with the melt.

12. A device as claimed in one or more of the preceding claims, characterised in that the inner wall of the crucible (14) is provided with a shell or an insert (28) composed of a material which does not react with the melt, and the feeding funnel (24) leads into a region of the crucible (14, 28) which is delimited on one side by the outer wall of the ring (29) and on the other side by the crucible edge (55).

13. A device as claimed in one or more of the preceding claims, characterised in that at least the ring-shaped, flat part (38, 60) of the second heating element (13, 59) arranged above the crucible (14, 28) is covered with a material which is free of abraded particles and scale and which ensures that no components of the heating element fall into the melt.

14. A device as claimed in one or more of the preceding claims, characterised in that the ring-shaped, flat part (60) of the second heating element (59) comprises a plurality of radially extending slots (63, 63',... and 64, 64',...) and is provided with at least one heater foot (61, 62) which extends vertically downwards from the edge of the flat part (60).

## Revendications

1. Appareillage pour le tirage de monocristaux hors d'un bain de fusion sous vide se trouvant dans un creuset (14, 28), comportant une chambre sous vide (52) dans laquelle est disposé le creuset (14, 28), ainsi qu'un premier corps chauffant plat (10), de forme à peu près annulaire et s'étendant dans un plan parallèle à la surface du fond (54) du creuset (14, 28), ainsi qu'un élément de tirage (49) au-dessus du bain de fusion et qu'une couverture (17, 17a, 18) située au-dessus du bain de fusion et présentant une ouverture (53) par laquelle on peut tirer, vers le haut, le monocristal depuis la surface du bain de fusion, au moyen de l'élément de tirage (49), et qui peut chauffer au moyen du rayonnement thermique d'un élément chauffant (10), appareillage caractérisé par un second corps chauffant (13), sensiblement en forme de cylindre circulaire, qui entoure au moins partiellement le creuset (14, 28), qui est disposé perpendiculairement au plan du premier corps chauffant (10) et dont le bord supérieur se transforme en un corps chauffant (38) à peu près en forme de plaque, parallèle au premier corps chauffant (10) et disposé dans un plan situé entre le bord supérieur (55) du creuset (14, 28) et la face inférieure de la couverture en forme de couronne circulaire (17, 17a, 18).

2. Appareillage pour le tirage de monocristaux hors d'un bain de fusion sous vide se trouvant dans un creuset (14, 28), comportant une chambre sous vide (52) dans laquelle est disposé le creuset (14, 28), ainsi qu'un premier corps chauffant plat (10), de forme à peu près annulaire et s'étendant dans un plan parallèle à la surface du fond (54) du creuset (14, 28), ainsi qu'une couverture (17, 17a, 18) située au-dessus du bain de fusion et présentant une ouverture (53) par laquelle on peut tirer, vers le haut, le monocristal depuis la surface du bain de fusion, au moyen de l'élément de tirage (49), appareillage caractérisé par un second corps chauffant plat (59), de forme sensiblement annulaire, qui est disposé dans un plan situé entre le bord supérieur (55) du creuset (14, 28) et la face inférieure de la couverture en forme de couronne circulaire (17, 17a, 18), appareillage dans lequel le second corps chauffant (59) présente un ou plusieurs pieds (61, 62) qui s'étendent verticalement vers le bas et qui viennent en prise dans des évidements (41, 41a) qui sont prévus dans des mors (12, 12a) qui sont solidement reliés aux amenées de courant (11, 11a), les pieds du corps chauffant étant bridés, coincés ou vissés dans les évidements.

3. Appareillage selon la revendication 1 ou 2, caractérisé par le fait que le premier corps chauffant plat (10), de forme annulaire, est fixé à au moins deux amenées de courant (9, 9a) disposées verticalement et en forme de barreau, les amenées de courant (9, 9a) étant fixées à la plaque de fond (3) du four (4, 4') et guidées vers l'extérieur par l'intermédiaire d'isolateurs.

4. Appareillage selon les revendications 1 à 3, caractérisé par le fait que les pieds (31, 32), solidement reliés avec les amenées de courant (9, 9a), du premier corps chauffant (10) sont reliés par l'intermédiaire de deux portions sensiblement en forme de demi-cercle, étant précisé que ces portions, qui enserrent l'ouverture centrale (35), sont constituées de serpentins chauffants (33, 34) cintrés en forme de méandre.

5. Appareillage selon les revendications 1 et 3, caractérisé par le fait que la partie plate, annulaire, du second corps chauffant de forme cylindrique (13) présente une pluralité de fentes (37, 37', ...) qui sont disposées réparties sur sa périphérie et qui s'étendent jusque dans la zone de la paroi latérale (39) en forme de cylindre circulaire.

6. Appareillage selon les revendications 1, 3 et 5, caractérisé par le fait que la paroi latérale (39) du second corps chauffant (13) sensiblement en forme de cylindre circulaire présente une pluralité de fentes (36, 36', ...) qui sont disposées réparties sur la périphérie de la paroi latérale (39) et qui s'étendent, depuis le bord inférieur (56) du corps chauffant, jusque dans la zone de la partie plate annulaire (38) du corps chauffant (13) qui s'étend radialement vers l'intérieur.

7. Appareillage selon une ou plusieurs des revendications précédentes, caractérisé par le fait que la paroi latérale (39) ou la partie plate annulaire (60) du second corps chauffant (13, 59) présente des parties formant pieds (40, 40a ou 61, 62) qui s'étendent vers le bas et viennent en prise dans des évidements (41, 41a) qui sont prévus dans des mors (12, 12a) qui s'étendent radielement vers l'intérieur et sont tenus par les amenées de courant (11, 11a), étant précisé que les pièces formant pieds (40, 40a) du second corps chauffant (13) sont coincées à l'aide de cales (42, 42a) dans les évidements à peu près rectangulaires (41, 41a) ou y sont vissées ou rivées.

8. Appareillage selon l'une ou plusieurs des revendications précédentes, caractérisé par le fait que la partie plate annulaire (38, 60) du second corps chauffant (13, 59) présente des ouvertures ou des évidements (57, 57a ou 65, 66) par lesquels passe l'entonnoir de remplissage (24) d'un tube d'amenée (23) d'un dispositif de chargement qui est prévu à l'extérieur du four (4, 4').

9. Appareillage selon l'une ou plusieurs des revendications précédentes, caractérisé par le fait que le creuset (14, 28) et les deux corps chauffants (10 ou 13, 59) sont au moins partiellement entourés d'un tube de protection (15), sensiblement cylindrique, qui, par son bord inférieur (71) présentant des évidements (43, 43', ...), repose sur une cuve (7) de capture de produit provenant du bain de fusion, cuve qui, de son côté, est tenue, sur la plaque de fond (3) du four, par une pièce formant support ou par un tube (5), étant précisé que la cuve de capture (7) du produit provenant du bain de fusion s'étend dans un plan parallèle au plan de la surface du fond (54) du creuset (14, 28) et présente un perçage central (58) par lequel passe la chandelle verticale (26) support du creuset.

10. Appareillage selon l'une ou plusieurs des revendications précédentes, caractérisé par le fait qu'aussi bien la cuve (7) de réception du produit provenant du bain de fusion que le tube de protection (15) et la plaque de couverture (17, 17a) disposée au-dessus du creuset (14, 28) et portée par le tube de protection (15), sont revêtus de tapis en matériau isolant (8, 16, 18) de préférence en feutre de graphite.

11. Appareillage selon l'une ou plusieurs des revendications précédentes, caractérisé par un anneau cylindrique creux (29), en un matériau ne réagissant pas avec le bain de fusion, inséré concentriquement dans le creuset (14, 28) du bain de fusion et présentant des ouvertures ou des découpes (30) pour le passage du bain de fusion.

12. Appareillage selon l'une ou plusieurs des revendications précédentes, caractérisé par le fait que la paroi intérieure du creuset (14) est munie d'une coque ou d'une garniture (28) en un matériau ne réagissant pas avec le bain de fusion et que l'entonnoir de remplissage (24) débouche dans une zone du creuset (14, 28) qui est limitée d'une part par la paroi extérieure de l'anneau (29) et d'autre part par le bord (55) du creuset.

13. Appareillage selon l'une ou plusieurs des revendications précédentes, caractérisé par le fait qu'au moins la partie annulaire plate (38, 60), disposée au-dessus du creuset (14, 28), du second corps chauffant (13, 59) est recouverte d'un matériau exempt de poussière d'usure ou de calamine, qui garantit qu'aucun constituant du corps chauffant ne tombe dans le bain de fusion.

14. Appareillage selon l'une ou plusieurs des revendications précédentes, caractérisé par le fait que la partie plate annulaire (60) du second corps chauffant présente une pluralité de fentes (63, 63', ... ou 64, 64', ...) qui s'étendent radialement et qu'elle est munie d'au moins un pied (61, 62) qui s'étend verticalement vers le bas depuis le bord de la partie plate (60).
